# EUROPÄISCHE PATENTSCHRIFT

(11) **EP 1 169 677 B1**
(45) Veröffentlichungstag und Bekanntmachung des Hinweises auf die Patenterteilung: **28.07.2004**
(21) Anmeldenummer: 00931012.9
(22) Anmeldetag: 05.04.2000
(51) Int. Cl.: G06F 11/20

(54) **PROGRAMMIERBARER FESTWERTSPEICHER UND VERFAHREN ZUM BETREIBEN DES FESTWERTSPEICHERS**
PROGRAMMABLE READ-ONLY MEMORY AND METHOD FOR OPERATING SAID READ-ONLY MEMORY
MEMOIRE MORTE PROGRAMMABLE, ET PROCEDE POUR FAIRE FONCTIONNER CETTE MEMOIRE MORTE

(30) Priorität: 09.04.1999 DE 19916065
(43) Veröffentlichungstag der Anmeldung: 09.01.2002
(73) Patentinhaber: Infineon Technologies AG, 81669 München (DE)
(72) Erfinder: KERN, Thomas, D-80798 München (DE); PETER, Jürgen, D-82024 Taufkirchen (DE)
(74) Vertreter: Jannig, Peter, Dipl.-Ing.
(86) Internationale Anmeldenummer: PCT/DE2000/001053
(87) Internationale Veröffentlichungsnummer: WO 2000/062166

(56) Entgegenhaltungen:
- EP-A- 0 756 287
- US-A- 4 802 117
- US-A- 5 127 097

## Beschreibung

Die vorliegende Erfindung betrifft einen programmierbaren Festwertspeicher gemäß dem Oberbegriff des Patentanspruchs 1 sowie ein Verfahren zum Betreiben des programmierbaren Festwertspeichers gemäß dem Oberbegriff des Patentanspruchs 9.

Programmierbare Festwertspeicher und Verfahren zum Betreiben von programmierbaren Festwertspeichern sind beispielsweise aus der US 4,802,117 und der US 5,127,097 bekannt.

Programmierbare Festwertspeicher bzw. nichtflüchtige Speicher sind in einer Vielzahl von Ausführungsformen wie z.B. PROMs, EPROMs, EEPROMs bekannt und bedürfen keiner näheren Erläuterung. Solche Speicher können als Datenspeicher oder als Programmspeicher ausgebildet sein. Insbesondere die als EEPROM ausgebildeten Festwertspeicher sind zwar programmierbar und löschbar, jedoch ist die maximale Zahl der möglichen Schreib/Löschzyklen - die sogenannte Endurance - nach oben hin begrenzt und hängt insbesondere vom Festwertspeichertyp ab.

Flashspeicher sind Festwertspeicher, die sich durch besonders einfache und schnelle Schreib/Löschvorgänge auszeichnen. Bei Flashspeichern sind die Speicherzellen zwar einzeln bzw. segmentweise elektrisch programmierbar, jedoch kann ein Flashspeicher nur segmentweise bzw. auch nur als Ganzes gelöscht werden. Der Löschvorgang erfolgt durch einen kurzen elektrischen Löschimpuls.

Flashspeicher zeichnen sich durch eine sehr niedrige Versorgungsspannung sowie eine geringe Verlustleistung aus und eignen sich somit insbesondere bei Systemen mit lokaler Spannungsversorgung, wie beispielsweise einem Mobilfunktelefon oder einem portablen Audiogerät.

Die Anforderungen an Flash-Datenspeichern sind im Gegensatz zu Flash-Programmspeichern gekennzeichnet durch eine wesentlich höhere Endurance sowie einer höheren Selektivität beim Programmieren und Löschen. Daneben weisen Datenspeicher gegenüber Programmspeichern in der Regel eine geringere Speichergröße auf.

Um die hohen Anforderungen an eine möglichst hohe Endurance sicherstellen zu können, werden Flash-Datenspeicher typischerweise über das sogenannte Fowler-Nordheim-Tunneln programmiert und gelöscht, da dieses Verfahren eine niedrigere und homogenere Belastung der einzelnen Speicherzellen bzw. deren Tunneloxid garantiert, als dies beispielsweise durch Programmieren mit heißen Elektronen (Channel-Hot-Electron) der Fall ist. Die Dicke des Tunneloxids bei solchen Speicherzellen ist vergleichsweise klein, wodurch die notwendigen Spannungen und Zeiten beim Programmieren und Löschen verhältnismäßig niedrig gehalten werden können.

Allerdings sind insbesondere Flashspeicher, die über Fowler-Nordheim-Tunneln programmiert und gelöscht werden, gekennzeichnet durch eine vergleichsweise hohe Anzahl von stochastischen Speicherdefekten, wie z. B. den sogenannten "Erratic Bits" und "Moving Bits". Erratic Bits sind Speicherzellen, die auf gleichen elektrischen Streß unterschiedlich reagieren, wodurch Speicherfehler direkt nach der Programmierung entstehen können. Moving Bits sind Speicherzellen, die ihre gespeicherte Ladung in relativ kurzer Zeit verlieren, wodurch die Speicherzellen ihren logischen Zustand über die Zeit ändern. Beide Speicherdefekte sind allerdings nicht reproduzierbar und treten stochastisch auf.

Typische Testprogramme auf Wafer- und Bausteinebene zur Sicherung der Qualität und der Zuverlässigkeit des Speichers eignen sich jedoch nur für reproduzierbare Speicherdefekte. Temporär defekte Speicherzellen, wie die Erratic Bits und Moving Bits, können durch die in diesen Testprogramm eingebauten Filter nicht oder nur zufällig erfaßt werden.

Eine Möglichkeit, dieser Art von Fehlern zu begegnen, sind intelligente Verfahren zur Erkennung und Korrektur solcher Defekte. Diese Verfahren benützen umfangreiche Codierungsalgorithmen, wie z. B. den Hamming-Code, bei dem der entsprechende Code in zusätzlichen Speicherzellen hinterlegt wird. Die Auswertung dieser codierten Information ist sehr aufwendig, da hierfür eine zusätzliche Bewerterschaltung sowie eine additive Logikschaltung für Schreib/Lesezugriffe erforderlich ist.

Der vorliegenden Erfindung liegt daher die Aufgabe zugrunde, einen programmierbaren Festwertspeicher sowie ein Verfahren zum Betreiben des Festwertspeichers anzugeben, bei dem mit minimalem Aufwand zuverlässig stochastische Speicherdefekte erkannt und ggf. korrigiert werden können.

Diese Aufgaben werden erfindungsgemäß durch einen programmierbaren Festwertspeicher mit den Merkmalen des Patentanspruchs 1 sowie ein Verfahren zum Betreiben des Festwertspeichers mit den Merkmalen des Patentanspruchs 9 gelöst.

Der erfindungsgemaße Festwertspeicher mit Redundanz zeichnet sich dadurch aus, daß die zu speichernden Daten und Programmteile zumindest doppelt abgespeichert werden. Dadurch lassen sich auf einfache Weise stochastische Defekte erkennen und korrigieren. Für das Redundanzkonzept ist vorteilhafterweise ein minimaler zusätzlicher Schaltungsaufwand erforderlich, da im wesentlichen ein analoger Multiplexer sowie die entsprechenden redundanten Speichersegmente erforderlich sind. Aufgrund der Tatsache, daß lediglich ein einziger Leseverstärker für alle Speichersegmente eines Speicherblocks erforderlich ist, ergibt sich kein zusätzlicher Stromverbrauch beim Lesen und Schreiben; darüber hinaus ergibt sich durch das parallele Auslesen und Beschreiben der Speichersegmente eines Speicherblocks nahezu keine Einbuße an die Geschwindigkeit bei Schreib-/Lesezugriffen.

In einer bevorzugten Ausführung des Festwertspeichers weist dieser eine doppelte Redundanz auf, d. h. pro Speicherblock sind ein Speichersegment und zwei redundante Speichersegmente vorgesehen. Mit einem doppelt redundanten Festwertspeicher lassen sich maximal zwei Speicherdefekte pro Speichersegmente erkennen. Die doppelte Redundanz bietet somit in aller Regel einen guten Kompromiß hinsichtlich der Anforderungen, daß stochastische Speicherdefekte definiert erkannt und korrigiert werden und andererseits der zusätzliche Flächenaufwand für die redundanten Speichersegmente nicht zu groß wird. Es wäre selbstverständlich auch eine geringere Redundanz oder eine Redundanz größer als zwei denkbar. Insbesondere der letztgenannte Fall ist dann von Vorteil, wenn der Dateninhalt eines Speichersegments sehr groß ist.

Der erfindungsgemäße Festwertspeicher ist segmentweise organisiert, d. h. jeweils ein Speichersegment weist eine größere Anzahl von Speicherzellen auf. Typischerweise weisen alle Speichersegmente des Festwertspeichers jeweils dieselbe Datenbreite, zum Beispiel ein Byte, ein Wort oder ein Doppelwort, auf.

In einer weiteren vorteilhaften Ausgestaltung weist der erfindungsgemäße Festwertspeicher zwei Betriebsmodi auf: den normalen Lese-/Schreibbetriebsmodus, bei dem alle Speichersegmente eines Speicherblocks gleichzeitig ausgelesen, beschrieben oder gelöscht werden, und den Testbetriebsmodus, bei dem jeweils ein einzelnes Speichersegment eines Speicherblocks ausgelesen, beschrieben oder gelöscht wird. Hierfür ist eine Multiplexerschaltung vorgesehen, die jeweils einen der beiden Betriebsmodi auswählt. Eine der Multiplexerschaltung nachgeschaltete Leseverstärkerschaltung ist ebenfalls an die beiden Betriebsmodi angepaßt, d. h. sie weist für jeden der Betriebsmodi einen entsprechenden Referenzpegel auf.

Besonders vorteilhaft ist es, wenn die genannte Leseverstärkerschaltung derart einstellbare Referenzpegel aufweist, daß unterschieden werden kann, ob die zu erwartenden stochastischen Defekte überwiegend als logische "0", als logische "1" oder sowohl als logische "0" als auch als logische "1" auftreten.

Die Erfindung eignet sich insbesondere bei programmierbaren Festwertspeicher, die als Flash-Speicher ausgebildet sind. Besonders vorteilhaft ist die Erfindung darüber hinaus bei solchen Flash-Speichern, die über das Fowler-Nordheim-Tunneln programmiert bzw. gelöscht werden, da diese aufgrund der geringeren Programmierspannung typischerweise eine höhere stochastische Defektdichte aufweisen, als über "heiße Elektronen" programmierte Flash-Speicher. Die vorliegende Erfindung ist jedoch nicht ausschließlich auf Flash-Speicher beschränkt, sondern kann auch sehr vorteilhaft bei anderen programmierbaren Festwertspeichern, wie beispielsweise EPROMs oder PROMs verwendet werden.

Darüber hinaus ist die vorliegende Erfindung besonders vorteilhaft bei Datenspeichern, da diese gegenüber üblichen Programmspeichern gekennzeichnet sind durch eine höhere Endurance und dadurch besonders anfällig sind auf die obengenannten stochastischen Speicherdefekte.

Vorteilhafte Ausgestaltungen und Weiterbildungen der Erfindung sind Gegenstand der Unteransprüche.

Die vorliegende Erfindung wird nachfolgend anhand der Figuren der Zeichnung näher erläutert. Es zeigt dabei:
- Figur 1: die Architektur eines erfindungsgemäßen programmierbaren Festwertspeichers mit doppelter Redundanz;
- Figur 2: zeigt schematisch einen Ausschnitt des Festwertspeichers aus Figur 1, anhand dessen die erfindungsgemäße Speicheranordnung mit Redundanz erläutert wird;
- Figur 3: anhand einiger Beispiele ein Verfahren für eine flexible Bitfehlerkorrektur durch Referenzpegelanpassung.

In allen Figuren der Zeichnung sind gleiche oder funktionsgleiche Elemente, sofern dies nicht anders angegeben ist, mit gleichen Bezugszeichen versehen.

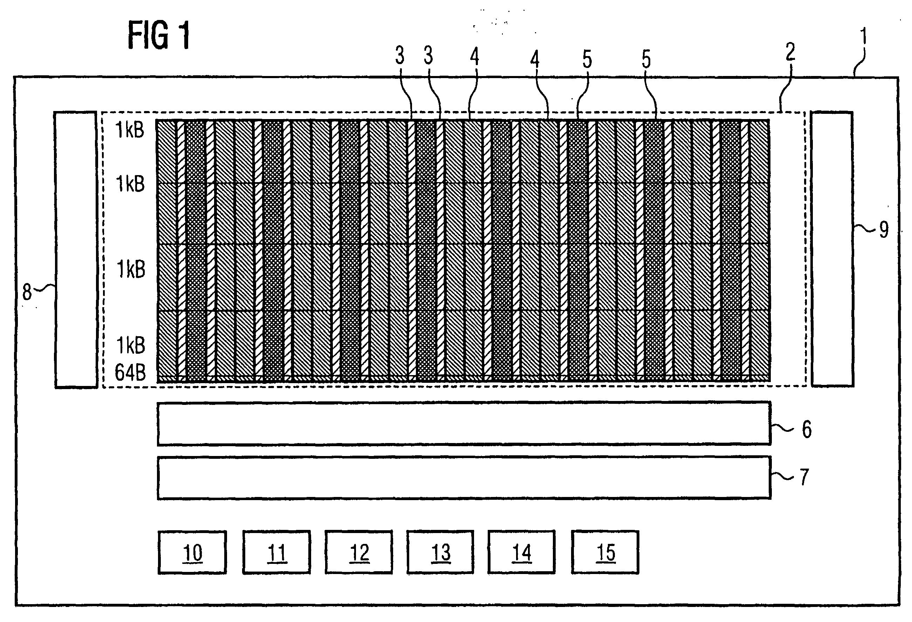

Figur 1 zeigt die Architektur eines erfindungsgemäßen programmierbaren Festwertspeichers mit doppelter Redundanz.

In Figur 1 ist mit 1 der programmierbare Festwertspeicher bezeichnet, der hier als Flash-Datenspeicher ausgebildet ist. Der Datenspeicher 1 weist im vorliegenden Ausführungsbeispiel eine 8 Bit Granularität auf, d. h. die Eingangs-/Ausgangseinheit (I/O-Ports) weisen eine Datenbreite von 8 Bit auf.

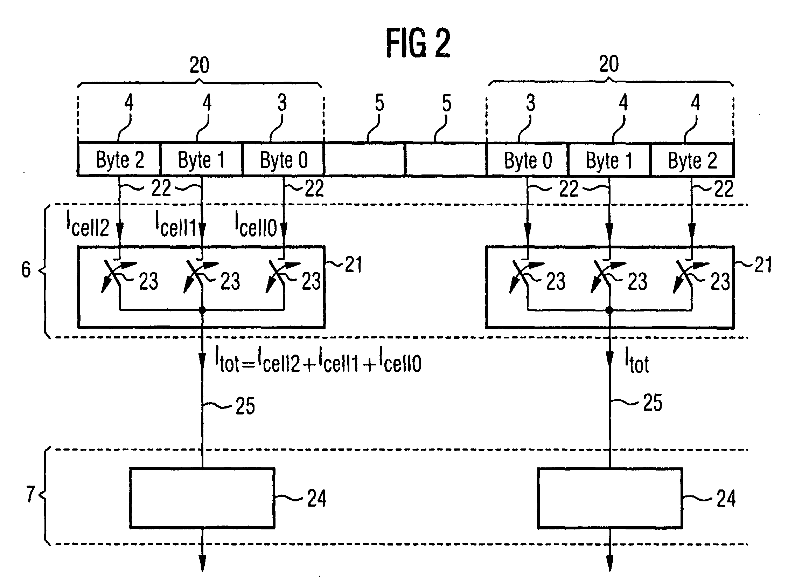

Figur 1 zeigt einen typischen Aufbau eines 8 Bit Datenspeichers 1, der ein Speicherzellenfeld 2 mit einer Vielzahl von einzelnen Speicherzellen (in Figur 1 nicht dargestellt) aufweist. Das Speicherzellenfeld 2 ist in Speichersegmente 3 und redundante Speichersegmente 4 unterteilt. Jedem Speichersegment 3 und den diesem Speichersegment 3 zugeordnete redundante Speichersegmente 4 ist jeweils ein sogenannter Byteschalter oder Auswahlsegment 5 zugeordnet. Die einzelnen Speichersegmente 3, redundanten Speichersegmente 4 sowie Auswahlsegmente sind in Figur 1 nicht einzeln dargestellt, sondern lediglich die entsprechenden, in Spalten zusammengefaßten Segmente 3, 4, 5, wobei die Auswahlsegmente 5 dunkel hinterlegt sind und die redundanten Speichersegmente 4 schraffiert dargestellt sind. Der genaue Aufbau der Segmente 3, 4, 5 wird nachfolgend anhand von Figur 2 noch genau beschrieben.

Ferner weist der Datenspeicher 1 in Figur 1 eine Auswahlschaltung 6, der zum Beispiel als Multiplexer ausgebildet sein kann, zur Auswahl der einzelnen Speichersegmente 3 bzw. redundanten Speichersegmente 4 auf. Die Auswahlschaltung 6 ist mit einem nachgeschalteten Spaltendecoder 7 zur Auswahl der unterschiedlichen Spalten verbunden. Für den Lesebetrieb weist der in bekannter Weise aufgebaute Spaltendecoder 7 eine Vielzahl von Leseverstärkerschaltungen auf. Ausgangsseitig ist der Spaltendecoder 7 mit einer der Granularität des Datenspeichers 1 entsprechenden Anzahl von I/O-Ports (in Figur 1 nicht dargestellt) verbunden.

Ferner weist der Datenspeicher 1 einen ersten Zeilendecoder 8, der die einzelnen Speicherzellen eines Speichersegments 3, 4 ansteuert, sowie einen zweiten Zeilendecoder, der die einzelnen Auswahlsegmente 5 ansteuert, auf.

Ein typischer Datenspeicher 1 weist wie in Figur 1 dargestellt, die folgenden Elemente auf: eine Ladungspumpe 10, eine Referenzschaltung 11, die beispielsweise als Oszillator für die Erzeugung des Takts für die Ladungspumpe bzw. der Referenzspannung vorgesehen ist, Schaltungsmittel zur Betriebsspannungs-/stromüberwachung (Power-Management), die zum Beispiel einen Stromsparmodus enthalten. Ferner kann der Datenspeicher 1 eine ICS-Schaltung 13 (Interface Control Statemachine), eine FAS-Schaltung 14 (Flash Area Statemachine) sowie eine Steuerschaltung 15, die den internen und externen Datentransfer steuert, enthalten.

Figur 2 zeigt schematisch einen Ausschnitt des Festwertspeichers aus Figur 1, anhand dessen die erfindungsgemäße Speicheranordnung mit Redundanz erläutert wird.

Figur 2 zeigt zwei Speichersegmente 3, denen jeweils zwei redundante Speichersegmente 4 zugeordnet sind. Jeweils ein Speichersegment 3 und diesem zugeordnete redundante Speichersegmente 4 bilden einen Speicherblock 20. Jedem Speicherblock 20 ist jeweils ein Auswahlsegment 5, das die Speicherzellen der Speichersegmente 3, 4 steuern, zugeordnet.

Die Speichersegmente 3 sowie redundanten Speichersegmente 4 sind typischerweise jedoch nicht notwendigerweise gleich groß, d. h. sie weisen dieselbe Datenbreite auf. Bei einer Datenbreite von einem Byte steuert also jedes Auswahlsegment 5 jeweils 1 Byte des physikalischen Speichers der Speichersegmente 3, 4 eines Speicherblocks 20 für die Operationen Lesen, Programmieren und Löschen.

Das Prinzip der vorliegenden Festspeicherarchitektur beruht darauf, daß in allen Speichersegmenten 3, 4 eines Speicherblocks 20 jeweils identische Daten, Programmteile oder sonstige Informationen abgelegt werden, d. h. im vorliegenden Ausführungsbeispiel liegt der Inhalt eines Speichersegmentes jeweils in dreifacher Form vor. Damit einhergehend ist, wie in den Figuren 1 und 2 dargestellt ist, jedoch lediglich eine Verdreifachung des physikalischen Speichers. Der Bereich der Auswahlsegmente 5 zur Steuerung der verschiedenen Speichersegmente 3, 4 wird hingegen nicht vergrößert.

Die Figuren 1 und 2 zeigen also eine Realisierung des erfindungsgemäßen Datenspeichers 1 mit doppelter Redundanz, d. h. es sind pro Dateninhalt eines Speichersegmentes 3, 4 maximal zwei Bitfehler korrigierbar.

Ferner zeigt Figur 2 eine Auswahlschaltung 6, die jeweils eine Multiplexerschaltung 21 für jeden der Speicherblöcke 20 enthalt. Die Multiplexerschaltungen 21 sind jeweils über parallel zueinander angeordnete Schreib-/Lesepfade 22 mit jedem Speichersegment 3, 4 verbunden. Über Schalter 23 in den Multiplexerschaltungen 21, die in die entsprechenden Schreib-/Lesepfade 22 geschaltet sind, lassen sich diese zuschalten oder wegschalten, so daß beispielsweise alle Speichersegmente 3, 4 eines Speicherblocks 20 einzeln oder gleichzeitig und somit parallel ausgelesen, beschrieben und gelöscht werden können.

Jede Multiplexerschaltung 21 ist über jeweils einen weiteren 8 Bit breiten Schreib-/Lesepfad 25 mit einer nachgeschalteten Leseverstärkerschaltung 24 verbunden. Die Leseverstärkerschaltung 24 erzeugt im Lesebetrieb ein 8 Bit breites Datensignal, das den entsprechenden Anschlüssen (I/O-Ports) des Datenspeichers 1 zugeführt wird.

Nachfolgend werden die verschiedenen Betriebsmodi Lesen, Programmieren und Löschen näher beschrieben:

### Lesen:

Die Daten in den drei Speichersegmenten 3, 4 eines Speicherblocks 20 werden nicht getrennt über separate Lesepfade 22 ausgewertet, sondern die Daten werden vielmehr über einen einzigen diesem Speicherblock 20 zugeordneten analogen Multiplexer 21 auf einem einzigen Lesepfad 25 zusammengeführt. Die Entscheidung über das auszugebende Datum wird im Lesepfad 25 von einem an die doppelte Redundanz des Datenspeichers 1 angepaßten Leseverstärker 24 übernommen. Die Aufgabe des Leseverstärkers 24 besteht allgemeinerweise darin, den Gesamtzellstrom Iₜₒₜ, der sich beim Auslesen ergibt, mit einem Referenzstrom I_{ref} zu vergleichen. Liegt dieser Gesamtzellstrom Iₜₒₜ über dem Referenzstrom I_{ref}, so wird z. B. eine logische "1" ausgegeben. Liegt er darunter, so wird als Datum eine logische "0" ausgegeben. Es wäre selbstverständlich auch eine hierzu inverse Logik denkbar.

Im Beispiel in Figur 2 wird jedoch dem Leseverstärker 24 beim Auslesen der drei Speichersegmente 3, 4 eines Speicherblocks 20 nicht der einfache Zellstrom, der sich beim Auslesen eines einzelnen Speichersegmentes ergibt, zugeführt, sondern vielmehr wird durch Zusammenführung bzw. Addition der Zellströme der drei Speichersegmente 3, 4 der sich durch Addition dieser Ströme ergebene Gesamtstrom (Iₜₒₜ = I_{cell0} + I_{cell1} + I_{cell2)} dem Leseverstärker 24 zugeführt. Der Leseverstärker 24 läßt sich durch einfache Kallibrierung und Anpassung des Referenzstromes I_{ref} an diese Gegebenheit anpassen.

Da im Lesebetrieb der Leseverstärker 24 den Hauptstromverbraucher darstellt, ist diese Realisierung nicht nur in Bezug auf eine minimale Chipfläche von Vorteil, sondern auch ohne zusätzliche Erhöhung des Stromverbrauchs durch Verwendung eines einzigen analogen Multiplexers 21 bzw. eines einzelnen Leseverstärkers 24 möglich.

Zusätzlich zu dem gerade beschriebene Betriebsmodus ("3 aus 3-Betrieb"), bei dem alle Speichersegmente 3, 4 eines Speicherblockes 20 gleichzeitig ausgelesen werden, kann auch ein zweiter Betriebsmodus ("1 aus 3-Betrieb") - beispielsweise zum Testen eines einzelnen Speichersegments 3, 4 auf "harte Fehler" - vorgesehen sein. Hierzu wird der Multiplexer 21 vom "3 aus 3-Betrieb" auf den "1 aus 3-Betrieb" umgeschaltet. Für diese Zwecke ist auch eine Umschaltung des Leseverstärkers 24 auf den jeweils einfachen Zellstrom durch Verschiebung des entsprechenden Referenzpegels auf einfache Weise möglich, wobei hier lediglich ein entsprechend der Redundanz geringerer Referenzpegel erforderlich ist.

### Programmieren:

Das Programmieren über die Schreib-/Lesepfade 22, 25 wird ebenfalls über die Multiplexer 21 der Auswahlschaltung 6 gesteuert. Das Programmieren der Speichersegmente 3, 4 eines Speicherblocks 20 erfolgt dabei - über die Multiplexer 21, jedoch ohne Zwischenschaltung des Leseverstärkers 24 - äquivalent wie der oben beschriebene Lesevorgang. Im "3 aus 3-Betrieb" werden also alle drei Speichersegmente 3, 4 parallel beschrieben, wahrend im Testbetrieb ("1 aus 3-Betrieb") auf ein einzelnes Speichersegment singulär zugegriffen werden kann.

### Löschen:

Im vorliegenden Ausführungsbeispiel erfolgt das Löschen des Inhalts der Speichersegmente 3, 4 eines Speicherblocks 20 immer parallel, d. h. alle Speichersegmente 3, 4 eines Speicherblocks 20 werden gleichzeitig gelöscht. Es wäre jedoch auch denkbar, daß äquivalent wie beim Lesen und Programmieren, die Speichersegmente 3, 4 auch einzeln gelöscht werden. Dies ist jedoch nur im Testbetriebsmodus sinnvoll.

Im Ausführungsbeispiel in Figur 2 wurde der entsprechende Referenzpegel genau in der Mitte zwischen den entsprechenden Strompegeln für eine logische "0" und einer logischen "1" angeordnet. Dies setzt jedoch voraus, daß stochastische Defekte beim Abspeichern von Daten gleichverteilt auftreten, d. h. es werden jeweils eine gleiche Anzahl von sogenannten korrupten "Nullen" und korrupten "Einsen" erzeugt. Mit korrupten "Nullen" und "Einsen" sind hier die entsprechenden Speicherdefekte bezeichnet. Dieser Fall kann jedoch nicht immer vorausgesetzt werden. Es ist daher wünschenswert, daß bei auftretenden stochastischen Defekten zwischen korrupten "Nullen" und "Einsen" unterschieden werden kann.

Die vorliegende Erfindung sieht dabei ein Verfahren zur Referenzpegelanpassung vor, bei dem die Referenzpegel des Leseverstärkers 24 verschiebbar und somit einstellbar sind. Die Festlegung der Referenzpegels I_{ref} geschieht typischerweise mittels einer entsprechenden Anzahl von Referenzzellen. Durch Zu- bzw. Abschalten dieser Referenzzellen läßt sich der Referenzpegel I_{ref} nach oben bzw. nach unten verschieben. Der Vorteil liegt darin, daß die Art der Fehler, die korrigiert werden können, frei wählbar ist und die Schaltung zur Referenzpegeleinstellung nicht hart verdrahtet sein muß. Darüber hinaus erfordert diese Flexibiltät in der Referenzpegelanpassung lediglich einen vernachlässigbaren zusätzlichen Flächenaufwand.

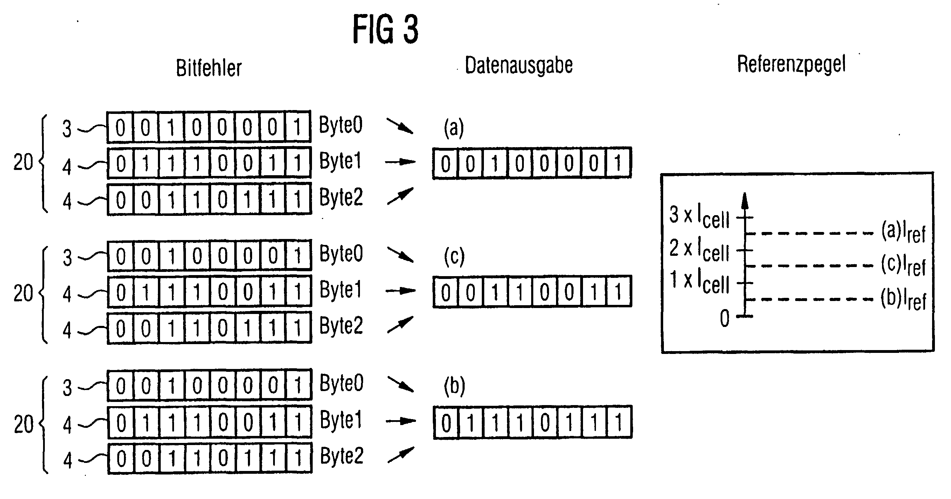

Anhand von Figur 3 werden nachfolgend drei Beispiele für eine flexible Bitfehlerkorrektur durch Referenzpegelanpassung beschrieben:
a) Die stochastischen Defekte sind überwiegend korrupte Nullen: Bei einer doppelten Redundanz eines Speichersegments werden maximal zwei korrupte Nullen korrigiert, jedoch keine korrupte Eins. Der entsprechende Referenzpegel I_{ref} liegt hier unterhalb des einfachen Zellstroms I_{cell}.
b) Die stochastischen Defekte sind überwiegend korrupte Einsen: Der Referenzpegel I_{ref} ist größer als der doppelte Zellstrom (2*I_{cell}) und kleiner als der dreifache Zellstrom (3*I_{cell}). Es werden dadurch bis zu zwei Einsen, jedoch keine Null korrigiert.
c) Die stochastischen Defekte sind etwa gleichverteilt, daß heißt es treten in etwa eine gleiche Anzahl von korrupten Einsen wie korrupten Nullen auf: Der Referenzpegel I_{ref} entspricht hier etwa dem 1,5-fachen Zellstrom I_{cell}. Beim Auslesen ist hier maximal eine korrupte Eins und maximal eine korrupte Null korrigierbar.

## Patentansprüche

1. Programmierbarer Festwertspeicher (1) mit mindestens einem Speicherzellenfeld (2) mit einer Vielzahl von Speicherzellen,
**dadurch gekennzeichnet,**
**daß** der programmierbare Festwertspeicher eine Mehrzahl von aus Speicherzellen aufgebauten Speichersegmenten(3) aufweist, in die Daten und/oder Programmteile ablegbar sind,
- wobei zumindest einem der Speichersegmente (3) mindestens ein aus Speicherzellen aufgebautes redundantes Speichersegment (4) zugeordnet ist,
- wobei jeweils ein Speichersegment (3) und die diesem zugeordneten redundanten Speichersegmente (4) zusammen einen Speicherblock (20) bilden, in dem alle Speichersegmente (3, 4) denselben Dateninhalt aufweisen,
- wobei die Speichersegmente (3, 4) eines Speicherblocks (20) gleichzeitig auslesbar, löschbar und/oder beschreibbar sind, und
- wobei die Daten, die beim Lesen aus den Speichersegmenten (3, 4) eines Speicherblocks (20) ausgegeben werden, auf einen einzigen Lesepfad (25) zusammengeführt werden.

2. Festwertspeicher nach Anspruch 1,
**dadurch gekennzeichnet,**
**daß** jedes Speichersegment (3, 4) eines Speicherblocks (20) über einen eigenen Schreib-/Lesepfad (22), die parallel zueinander angeordnet sind, mit einer Auswahlschaltung (6, 21) verbunden ist.

3. Festwertspeicher nach Anspruch 2,
**dadurch gekennzeichnet,**
**daß** die Auswahlschaltung (6, 21) ein Multiplexer (21) ist, über den in einem ersten Betriebsmodus ein einzelnes Speichersegment (3, 4) und über den in einem zweiten Betriebsmodus alle Speichersegmente (3, 4) eines Speicherblocks (20) gleichzeitig auslesbar, beschreibbar oder löschbar sind.

4. Festwertspeicher nach einem der Ansprüche 2 oder 3,
**dadurch gekennzeichnet,**
**daß** der Auswahlschaltung (6, 21) in einem Lesebetriebsmodus eine Leseverstärkerschaltung (24) zugeschaltet ist, die sowohl zum Auslesen eines einzelnen Speichersegments (3, 4) oder aller Speichersegmente (3, 4) eines Speicherblocks (20) geeignet ist und die zu diesem Zweck mindestens zwei verschiedene Referenzpegel (I_{ref}) aufweist.

5. Festwertspeicher nach Anspruch 4,
**dadurch gekennzeichnet,**
**daß** die mindestens zwei verschiedenen Referenzpegel (I_{ref}) der Leseverstärkerschaltung (24) einstellbar sind, je nachdem, ob beim Beschreiben, Löschen oder Auslesen der Speicherzellen auftretende Defekte überwiegend als logische "1" oder als logische "0" oder sowohl als logische "1" als auch als logische "0" auftreten.

6. Festwertspeicher nach einem der vorstehenden Ansprüche,
**dadurch gekennzeichnet,**
**daß** alle Speichersegmente (3, 4) des Festwertspeichers (1) dieselbe Bitbreite aufweisen und jedem Speichersegment (3) eines Speicherblocks (20) genau ein oder zwei redundante Speichersegmente (4) zugeordnet sind.

7. Festwertspeicher nach einem der vorstehenden Ansprüche,
**dadurch gekennzeichnet,**
**daß** der Festwertspeicher (1) als integrierter Datenspeicher ausgebildet ist.

8. Festwertspeicher nach einem der vorstehenden Ansprüche,
**dadurch gekennzeichnet,**
**daß** der Festwertspeicher (1) als Flash-Speicher ausgebildet ist, der über das Fowler-Nordheim-Tunneln programmierbar und löschbar ist.

9. Verfahren zum Betreiben eines Festwertspeichers (1) nach einem der vorstehenden Ansprüche,
**dadurch gekennzeichnet,**
**daß** für die Operationen Lesen, Programmieren und Löschen ein erster und/oder ein zweiter Betriebsmodus vorgesehen ist,
- wobei im ersten Betriebsmodus eine Auswahlschaltung (6, 21) über jeweils einen Schreib/Lesepfad (22) auf alle Speichersegmente (3, 4) eines Speicherblocks (20) gleichzeitig zugreift und Zellströme der Speichersegmente auf einem einzigen Lesepfad zusammengeführt werden, und
- im zweiten Betriebsmodus die Auswahlschaltung (6, 21) über einen Schreib/Lesepfad (22) auf ein einzelnes Speichersegment (3, 4) eines Speicherblocks (20) zugreift.

10. Verfahren nach Anspruch 9,
**dadurch gekennzeichnet,**
**daß** für eine Lese-Operation eine Leseverstärkerschaltung (24) vorgesehen ist,
- der im ersten Beriebsmodus über die Auswahlschaltung (6, 21) die Summe der Zellströme (Iₜₒₜ) aller Speichersegmente (3, 4) eines Speicherblockes (20) zugeführt werden, wobei die Leseverstärkerschaltung (24) daraus und in Abhängigkeit eines ersten Referenzpegels (I_{ref}) ein Datenausgangssignal erzeugt, und
- der im zweiten Betriebsmodus über die Auswahlschaltung (₆, 21) ein einzelner Zellstrom (I_{cell}) eines einzelnen Speichersegments (3, 4) zugeführt wird, wobei die Leseverstärkerschaltung (24) daraus und in Abhängigkeit eines zweiten Referenzpegels (I_{ref}) ein Datenausgangssignal erzeugt.

11. Verfahren nach Anspruch 9 oder 10,
**dadurch gekennzeichnet,**
**daß** in Abhängigkeit davon, ob die beim Beschreiben, Löschen oder Auslesen erzeugten Defekte überwiegend als logische "1" oder als logische "0" oder sowohl als logische "1" als auch als logische "0" auftreten, in einer Leseverstärkerschaltung (24) Referenzelemente zugeschaltet oder weggeschaltet werden und dadurch der erste Referenzpegel (I_{ref}) durch Veränderung an diese auftretenden Defekte angepaßt wird.

## Claims

1. Programmable read-only memory (1) having at least one memory cell array (2) with a multiplicity of memory cells **characterized in that** the programmable read-only memory has a multiplicity of memory segments (3) which are composed of memory cells and in which data and/or program parts can be stored,
- at least one redundant memory segment (4) which is composed of memory cells being assigned to at least one of the memory segments (3),
- in each case one memory segment (3) and the redundant memory segments (4) assigned thereto together forming a memory block (20) in which all the memory segments (3, 4) have the same data content,
- the memory segments (3, 4) of a memory block (20) being able to be read, erased and/or written to simultaneously, and
- the date items, which are output from the memory segments (3, 4) of a memory block (20), being combined on a single read path (25) during the reading operation.

2. Read-only memory according to Claim 1, **characterized in that** each memory segment (3, 4) of a memory block (20) is connected via its own write/read path (22) to a selection circuit (6, 21), said write/read paths (22) being arranged in parallel with one another.

3. Read-only memory according to Claim 2, **characterized in that** the selection circuit (6, 21) is a multiplexer (21) via which, in a first operating mode, a single memory segment (3, 4) of a memory block (20) can be read, written to or erased, and via which, in a second operating mode, all the memory segments (3, 4) of a memory block (20) can be simultaneously read, written to or erased.

4. Read-only memory according to one of Claims 2 or 3, **characterized in that**, in a read operating mode, a sense amplifier circuit (24) is connected to the selection circuit (6, 21), said sense amplifier circuit (24) being suitable for reading a single memory segment (3, 4) or all the memory segments (3, 4) of a memory block (20) and having, for this purpose, at least two different reference levels (I_{ref}).

5. Read-only memory according to Claim 4, **characterized in that** the at least two different reference levels (I_{ref}) of the sense amplifier circuit (24) are adjustable depending on whether defects occurring during the writing to, erasure or reading of the memory cells occur predominantly as logic "1" or as logic "0" or as both logic "1" and logic "0".

6. Read-only memory according to one of the preceding claims, **characterized in that** all the memory segments (3, 4) of the read-only memory (1) have the same bit length, and each memory segment (3) of a memory block (20) is assigned precisely one or two redundant memory segments (4).

7. Read-only memory according to one of the preceding claims, **characterized in that** the read-only memory (1) is embodied as an integrated data memory.

8. Read-only memory according to one of the preceding claims, **characterized in that** the read-only memory (1) is embodied as a flash memory which can be programmed and erased by means of Fowler-Nordheim tunnelling.

9. Method for operating a read-only memory (1) according to one of the preceding claims, **characterized in that** a first and/or a second operating mode are/is provided for the operations of reading, programming and erasing,
- in which, in the first operating mode, a selection circuit (6, 21) simultaneously accesses all the memory segments (3, 4) of a memory block (20) via one write/read path (22) in each case and cell currents of the memory segments being combined on a single read path, and
- in the second operating mode, the selection circuit (6, 21) accesses an individual memory segment (3, 4) of a memory block (20) via one write/read path (22).

10. Method according to Claim 9, **characterized in that**, for a read operation, a sense amplifier circuit (24) is provided,
- which is supplied, in the first operating mode, with the sum of the cell currents (Iₜₒₜ) of all the memory segments (3,4) of a memory block (20) via the selection circuit (6, 21), the sense amplifier circuit (24) generating a data output signal therefrom and as a function of a first reference level (I_{ref}), and
- which is supplied, in the second operating mode, with a single cell current (I_{cell}) of an individual memory segment (3, 4) via the selection circuit (6, 21), the sense amplifier circuit (24) generating a data output signal therefrom and as a function of a second reference level (I_{ref}).

11. Method according to Claim 9 or 10, **characterized in that** reference elements are connected into the circuit or disconnected from the circuit in the sense amplifier circuit (24) as a function of whether the defects generated during the writing, erasure or reading occur predominantly as logic "1" or as logic "0" or as both logic "1" and logic "0", and as a result the first reference level (I_{ref}) is adapted, by changing it, to these defects which occur.

## Revendications

1. Mémoire fixe programmable (1) avec au moins un champ de cellules de mémoire (2) comportant une pluralité de cellules de mémoire, **caractérisée en ce que** la mémoire fixe programmable est munie d'une pluralité de segments de mémoire (3) constitués de cellules de mémoire, dans lesquels on peut sauvegarder des données et/ou des parties de programmes,
- au moins un segment de mémoire redondant (4) constitué de cellules de mémoire étant associé à au moins l'un des segments de mémoire (3),
- à chaque fois un segment de mémoire (3) et les segments de mémoire redondants (4) associés à ce dernier formant ensemble un bloc de mémoire (20), dans lequel tous les segments de mémoire (3, 4) présentent le même contenu de données,
- les segments de mémoire (3, 4) d'un bloc de mémoire (20) pouvant être lus, effacés et/ou écrits simultanément et
- les données émises lors de la lecture hors des segments de mémoire (3, 4) d'un bloc de mémoire (20) étant regroupées sur un chemin de lecture (25) unique.

2. Mémoire fixe selon la revendication 1, **caractérisée en ce que** chacun des segments de mémoire (3, 4) d'un bloc de mémoire (20) est relié à un circuit de sélection (6, 21), par l'intermédiaire d'un propre chemin d'écriture / de lecture (22), qui sont disposés en parallèle les uns par rapport aux autres.

3. Mémoire fixe selon la revendication 2, **caractérisée en ce que** le circuit de sélection (6, 21) est un multiplexeur, par l'intermédiaire duquel sous un premier mode d'exploitation un segment de mémoire (3, 4) individuel et par l'intermédiaire duquel sous un second mode d'exploitation tous les segments de mémoire (3, 4) d'un bloc de mémoire (20) peuvent être lus, écrits ou effacés simultanément.

4. Mémoire fixe selon l'une quelconque des revendications 2 ou 3, **caractérisée en ce que** sous un mode d'exploitation en lecture, un circuit amplificateur de lecture (24), qui est aussi bien adapté pour la lecture d'un segment de mémoire (3, 4) individuel ou de tous les segments de mémoire (3, 4) d'un bloc de mémoire (20) et qui à cet effet présente au moins deux différents niveaux de référence (I_{ref}), est connecté au circuit de sélection (6, 21)

5. Mémoire fixe selon la revendication 4, **caractérisée en ce que** les différents niveaux de référence (I_{ref}) qui sont au moins au nombre de deux, du circuit amplificateur de lecture (24) sont réglables selon que les défauts apparaissant lors de l'écriture, lors de l'effacement ou lors de la lecture des cellules de mémoire sont majoritairement des « 1 » logiques ou des « 0 » logiques ou tout aussi bien des « 1 » logiques que des « 0 » logiques.

6. Mémoire fixe selon l'une quelconque des revendications précédentes, **caractérisée en ce que** tous les segments de mémoire (3, 4) de la mémoire fixe (1) présentent la même largeur de bits et exactement un ou deux segments de mémoire redondants (4) sont affectés à chaque segment de mémoire (3) d'un bloc de mémoire (20).

7. Mémoire fixe selon l'une quelconque des revendications précédentes, **caractérisée en ce que** la mémoire fixe (1) est conçue sous forme d'une mémoire de données intégrée.

8. Mémoire fixe selon l'une quelconque des revendications précédentes, **caractérisée en ce que** la mémoire fixe (1) est conçue sous la forme d'une mémoire flash, programmable et effaçable par tunnel Fowler-Nordheim.

9. Procédé d'exploitation d'une mémoire fixe (1) selon l'une quelconque des revendications précédentes, **caractérisé en ce qu'**un premier et/ou un second mode d'exploitation est prévu pour les opérations de lecture, de programmation et d'effacement,
- sous le premier mode d'exploitation, un circuit de sélection (6, 21) accédant simultanément à tous les segments de mémoire (3, 4) d'un bloc de mémoire (20), par l'intermédiaire de respectivement un chemin d'écriture /de lecture (22) et des courants cellulaires des segments de mémoire étant regroupés sur un seul chemin de lecture, et
- sous un second mode d'exploitation, le circuit de sélection (6, 21) accédant à un segment de mémoire (3, 4) individuel d'un bloc de mémoire (20), par l'intermédiaire d'un chemin d'écriture / de lecture (22).

10. Procédé selon la revendication 9, **caractérisé en ce que** pour une opération de lecture, on a prévu un circuit amplificateur de lecture (24)
- auquel sous un premier mode d'exploitation, la somme des courants cellulaires (Iₜₒₜ) de tous les segments de mémoire (3, 4) d'un bloc de mémoire (20) est amenée par l'intermédiaire du circuit de sélection (6, 21), le circuit amplificateur de lecture (24) générant à partir de cette somme un signal de sortie de données, en fonction d'un premier niveau de référence (I_{ref}), et
- auquel sous un second mode d'exploitation, un courant cellulaire unique (I_{cell}) d'un segment de mémoire individuel (3, 4) est amené par l'intermédiaire du circuit de sélection (6, 21), le circuit amplificateur de lecture (24) générant à partir de ce courant un signal de sortie de données, en fonction d'un second niveau de référence (I_{ref}).

11. Procédé selon l'une quelconque des revendications 9 ou 10, **caractérisé en ce que** selon que les défauts générés lors de l'écriture, lors de l'effacement ou lors de la lecture sont majoritairement des « 1 » logiques ou des « 0 » logiques ou tout aussi bien des « 1 » logiques que des « 0 » logiques, des éléments de référence sont connectés ou déconnectés dans un circuit amplificateur de lecture (24) et de ce fait le premier niveau de référence (I_{ref}) est adapté par modification à ces défauts qui apparaissent.
